# EUROPEAN PATENT APPLICATION

(11) **EP 4 040 358 A1**
(43) Date of publication of application: **10.08.2022**
(21) Application number: 19947641.7
(22) Date of filing: 01.10.2019
(51) Int. Cl.: G06Q 10/10, G06Q 50/08, G06F 30/10

(54) **PROJECT MANAGEMENT DEVICE, PROJECT MANAGEMENT METHOD, AND RECORDING MEDIUM**

(71) Applicant: JGC Corporation, Nishi-ku Yokohama-shi Kanagawa 220-6001 (JP)
(72) Inventor: KOJIMA, Kazuyuki, Yokohama-shi, Kanagawa 220-6001 (JP); OHARA, Hiroki, Yokohama-shi, Kanagawa 220-6001 (JP); YU, Ming, Yokohama-shi, Kanagawa 220-6001 (JP); OOSATO, Erio, Yokohama-shi, Kanagawa 220-6001 (JP)
(74) Representative: Becker, Eberhard
(86) International application number: PCT/JP2019/038809
(87) International publication number: WO 2021/064876

(57) **Abstract**

This project management device for managing a project for building an object to be constructed is provided with: a display control unit that causes a display device to display a simulation model of the object to be constructed; a reception unit that receives a user's operation; a setting unit that sets the order of a plurality of work packages which are work units for building the object on the basis of the user's operation to the simulation model; and a generation unit that generates a schedule of the project on the basis of the order.

## Description

### Technical Field

This disclosure relates to a project management apparatus, a project management method, and a recording medium.

### Background Art

Hitherto, there have been known project management methods for managing a project for constructing a construction object through use of a graphical user interface (for example, see Patent Literature 1 and Patent Literature 2).

### Citation List

### Patent Literature

[PTL 1] WO 2019/040078 A1
[PTL 2] US 2017/0068933 A1

### Summary of Invention

### Technical Problem

With the above-mentioned project management methods, the project may be managed through use of a work package, which is a work unit. There are some work packages that can be started only after a certain work package is completed, and it is thus required to create a schedule of the project in consideration of a relationship among work packages. However, as a construction object becomes more complex, the relationship among a plurality of work packages also becomes more complex, and hence it may take an enormous amount of time to create the schedule of the project in consideration of the relationship among the plurality of work 1 packages.

This disclosure describes a project management apparatus, a project management method, and a recording medium, which are capable of simplifying generation of a schedule of a project.

### Solution to Problem

A project management apparatus according to one aspect of this disclosure is an apparatus configured to manage a project of constructing a construction object. The project management apparatus includes: a display control unit configured to display on a display apparatus a simulation model of the construction object; a reception unit configured to receive an operation of a user; a setting unit configured to set an order of a plurality of work packages, which are work units for constructing the construction object, based on an operation of the user on the simulation model; and a generation unit configured to generate a schedule of the project based on the order.

A project management method according to another aspect of this disclosure is a method of managing a project of constructing a construction object. The project management method includes: displaying on a display apparatus a simulation model of the construction object; setting an order of a plurality of work packages, which are work units for constructing the construction object, based on an operation of a user on the simulation model; and generating a schedule of the project based on the order.

A recording medium according to still another aspect of this disclosure is a computer-readable recording medium having recoded thereon a project management program for causing a computer to manage a project of constructing a construction object. The project management program is a program for causing a computer to execute the procedures of: displaying on a display apparatus a simulation model of the construction object; setting an order of a plurality of work packages, which are work units for constructing the construction object, based on an operation of a user on the simulation model; and generating a schedule of the project based on the order.

In the project management apparatus, the project management method, and the recording medium, the simulation model of the construction object is displayed on the display apparatus, and hence the user can use the simulation model to check a relationship among the plurality of work packages. For example, a work package to be executed before a certain work package can easily be discriminated. Thus, the user can set the order of the plurality of work packages while checking the relationship among the plurality of work packages in the simulation model. The schedule of the project is generated based on the order set in such a manner, and hence the generation of the schedule of the project can be simplified.

The project management apparatus may further include a registration unit configured to register, based on an operation of the user on the simulation model, one or more components out of a plurality of components forming the construction object in each of the plurality of work packages. In this case, the user can check the relationship among the plurality of components forming the construction object in the simulation model. For example, a plurality of components of the same type, and close to one another can be registered in one work package. Thus, through use of the simulation model, the components can be registered in the work package based on visual information, and hence the efficiency of the work of registering the components in the work package can be increased.

The display control unit may be configured to display the simulation model on the display apparatus in such a form that the order is identifiable. In this case, the order of the plurality of work packages can be visually recognized.

The project management apparatus may further include an adjustment unit configured to adjust the schedule. The display control unit may be configured to display the schedule on the display apparatus, and the adjustment unit may be configured to adjust the schedule based on an operation of the user. In this case, the schedule can finely be adjusted as required.

The project management apparatus may further include a calculation unit configured to calculate a work volume based on the schedule. In this case, the work volume is calculated in consideration of a work package that is required to be preceded, and hence a work volume that can actually be performed can be obtained. Therefore, calculation accuracy of the work volume increases, and hence resources, for example, workers, can efficiently be assigned based on the work volume.

The simulation model may be a 3D model of the construction object. In this case, the user can check a 3D shape of the construction object, and can thus more clearly recognize the relationship among the plurality of work packages. As a result, the user can appropriately set the order of the plurality of work packages, and hence the generation of the schedule of the project can further be simplified.

### Advantageous Effects of Invention

According to the respective aspects and embodiments of this disclosure, the generation of the schedule of the project can be simplified.

### Brief Description of Drawings

FIG. 1 is a configuration diagram for schematically illustrating a project management system including a project management apparatus according to an embodiment of this disclosure.
FIG. 2 is a hardware configuration diagram for illustrating the project management apparatus illustrated in FIG. 1.
FIG. 3 is a table for showing a configuration example of a work package DB illustrated in FIG. 1.
FIG. 4 is a table for showing a configuration example of a work volume DB illustrated in FIG. 1.
FIG. 5 is a table for showing a configuration example of a drawing DB illustrated in FIG. 1.
FIG. 6 is a flowchart for illustrating a series of procedures of a project management method to be executed by the project management apparatus illustrated in FIG. 1.
FIG. 7 is a diagram for illustrating processing of registering components in work packages.
FIG. 8 is a diagram for illustrating the processing of registering the components in the work packages.
FIG. 9 is a diagram for illustrating the processing of registering the components in the work packages.
FIG. 10 is a diagram for illustrating the processing of registering the components in the work packages.
FIG. 11 is a diagram for illustrating processing of setting an order of the work packages.
FIG. 12 is a diagram for illustrating the processing of setting the order of the work packages.
FIG. 13 is a diagram for illustrating the processing of setting the order of the work packages.
FIG. 14 is a diagram for illustrating the processing of setting the order of the work packages.
FIG. 15 is a diagram for illustrating processing of adjusting a schedule.
FIG. 16 is a graph for showing an example of a calculation result of work volumes.
FIG. 17 is a graph for showing a comparative example of the calculation result of the work volumes.
FIG. 18 is a diagram for illustrating a configuration of a project management program recorded in a recording medium.

### Description of Embodiments

A detailed description is now given of an embodiment of this disclosure with reference to the accompanying drawings. In the description of the drawings, the same components are denoted by the same reference numerals, and a redundant description thereof is omitted.

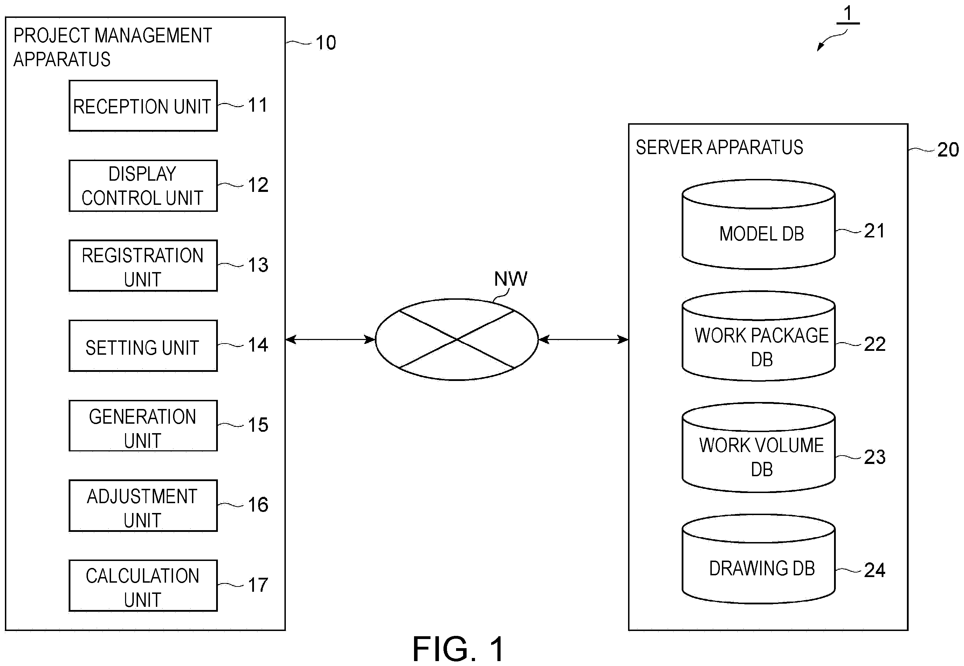

FIG. 1 is a configuration diagram for schematically illustrating a project management system including a project management apparatus according to the embodiment. The project management system 1 illustrated in FIG. 1 is a system configured to manage a project of constructing a construction object. Examples of the construction object include a plant in a field of oil/gas and a plant in a field of infrastructure. Examples of the plant in the oil/gas field include a petroleum refinery plant, a gas treatment plant, a natural gas liquefying plant, a petrochemical plant, and a chemical product manufacturing plant. Examples of the plant in the infrastructure field include a thermal power generation plant, an atomic power generation plant, and a renewable energy power generation plant. The project may include three phases, which are engineering, procurement, and construction.

The project management system 1 uses, for example, Advanced Work Packaging (AWP) to manage a project. The AWP is a method of managing a project through use of work packages. The work package is a work unit for constructing the construction object. Details of a work, a man-hour, a cost, resources, a schedule, and the like are assigned to the work package. Examples of the work package include an engineering work package (EWP), a procurement work package (PWP), a construction work package (CWP), and an installation work package (IWP). The EWP is a work unit of the engineering. The PWP is a work unit of the procurement. The CWP is a work unit of the construction. The IWP is obtained by subdividing the CWP. The IWP is a work unit for a work supervisor to manage a site work, and is a work that can be completed in, for example, four weeks or less.

The project management system 1 includes one or a plurality of project management apparatus 10 and a server apparatus 20. In a description given below, such a configuration that the project management system 1 includes one project management apparatus 10 is exemplified. The project management apparatus 10 and the server apparatus 20 are connected to each other for communication through a network NW The network NW may be any one of a wired network and a wireless network. Examples of the network NW include the Internet, a mobile communication network, and a wide area network (WAN).

The project management apparatus 10 is an apparatus configured to manage a project for constructing a construction object. The project management apparatus 10 is used by a user, and executes various types of procedures based on an operation of the user. Examples of the project management apparatus 10 include a desktop personal computer (PC), a notebook PC, a tablet terminal, and a smartphone.

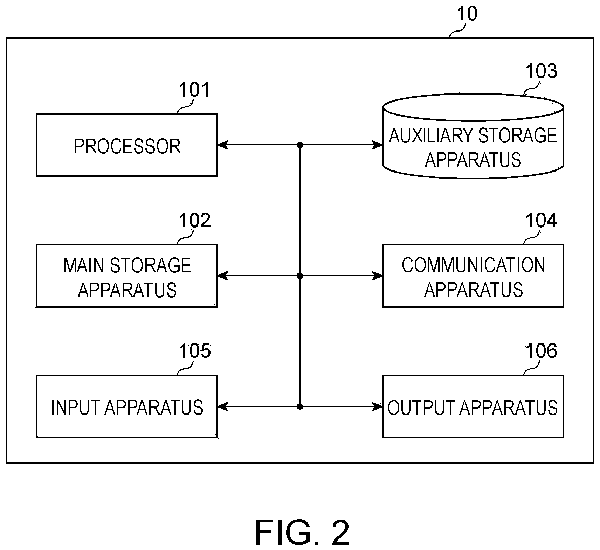

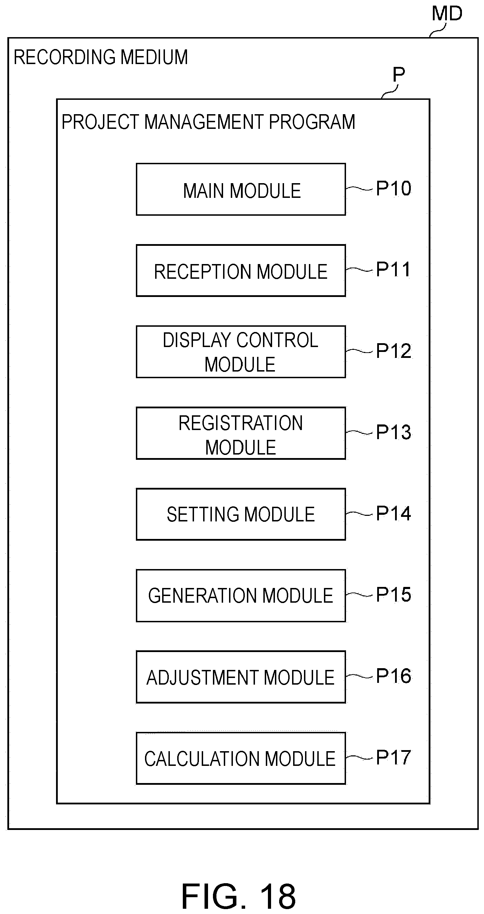

FIG. 2 is a hardware configuration diagram for illustrating the project management apparatus illustrated in FIG. 1. As illustrated in FIG. 2, the project management apparatus 10 may be physically constructed as a computer including hardware components such as one or a plurality of processors 101, a main storage apparatus 102, an auxiliary storage apparatus 103, a communication apparatus 104, an input apparatus 105, and an output apparatus 106. Examples of the processor 101 include a central processing unit (CPU). The main storage apparatus 102 is constructed by a random access memory (RAM), a read only memory (ROM), and the like. Examples of the auxiliary storage apparatus 103 include a semiconductor memory and a hard disk drive. The auxiliary storage apparatus 103 is configured to store a project management program P (see FIG. 18).

The communication apparatus 104 is an apparatus configured to transmit and receive data to and from other apparatus through the network NW The communication apparatus 104 is constructed by, for example, a network interface card (NIC) or a wireless communication module. Encryption may be used for the transmission/reception of data through the network NW The input apparatus 105 is an apparatus to be used when the user operates the project management apparatus 10. The input apparatus 105 is constructed by, for example, a touch panel, a keyboard, and a mouse. The output apparatus 106 is an apparatus configured to output various types of information to the user of the project management apparatus 10. The output apparatus 106 is constructed by, for example, a display and a speaker.

The processor 101 reads the project management program P stored in the auxiliary storage apparatus 103 onto the main storage apparatus 102, and executes the project management program P so that the respective pieces of hardware operate under the control of the processor 101, and data is read from and written to the main storage apparatus 102 and the auxiliary storage apparatus 103. As a result, respective function units of the project management apparatus 10 illustrated in FIG. 1 are implemented.

The server apparatus 20 is an apparatus that functions as a database configured to store various types of information. The server apparatus 20 has the same hardware configuration as that of the project management apparatus 10. The server apparatus 20 may not include the input apparatus 105 and the output apparatus 106. As illustrated in FIG. 1, the server apparatus 20 functionally includes a model DB 21, a work package DB 22, a work volume DB 23, and a drawing DB 24.

The model DB 21 stores a plurality of pieces of model information. The model information is set for each component. The component is an element forming a construction object. Examples of the component include a foundation, a steel structure, a piping, an apparatus, paint, a heat insulation material, an electrical component, instrumentation, and an underground structure. Each piece of model information contains a component identifier (ID), simulation model data, an area ID, and position information.

The component ID is information that enables a component to be uniquely identified. The simulation model data is simulation model data on the component identified by the component ID. In this embodiment, a 3D model data is used as the simulation model data. The area ID is information that enables identification of an area to which the component identified by the component ID belongs. The area in which the project is performed is divided into a plurality of areas. The position information is information indicating a position of the component identified by the component ID (location at which the component is arranged).

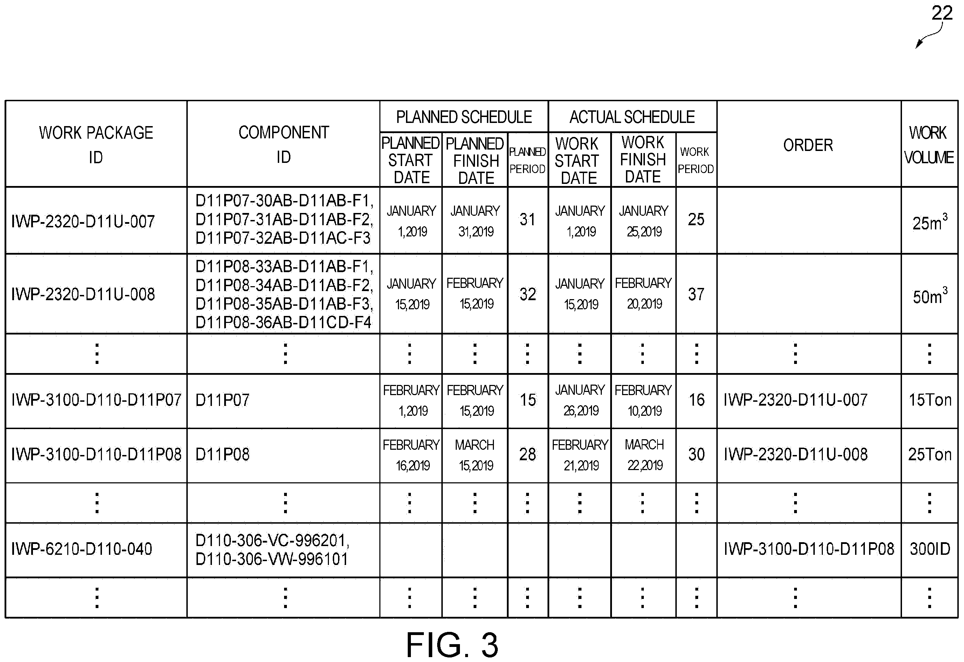

The work package DB 22 stores a plurality of pieces of work package information. The work package information is set for each work package. As shown in FIG. 3, each piece of work package information contains a work package ID, a component ID, planned schedule information, actual schedule information, order information, and work package work volume information.

The work package ID is information that enables a work package to be uniquely identified. The component ID is identification information on a component registered in the work package identified by the work package ID. The planned schedule information contains a planned start date, a planned finish date, and a planned period. The planned start date is a date on which a work of the work package identified by the work package ID is planned to be started. The planned finish date is a date on which the work of the work package identified by the work package ID is planned to be finished. The planned period is the number of days required for the work of the work package identified by the work package ID.

The actual schedule information contains a work start date, a work finish date, and a work period. The work start date is an actual date on which the work of the work package identified by the work package ID is started. The work finish date is an actual date on which the work of the work package identified by the work package ID is finished. The work period is an actual number of days required for the work of the work package identified by the work package ID.

The order information is information for defining an order of executing a work package. In this embodiment, as the order information, information for identifying a work package to be executed before the work package identified by the work package ID is used. In the example shown in FIG. 3, a work package ID of a work package to be executed immediately before the work package identified by the work package ID is used as the order information. The work package work volume information is information on a work volume of the work package identified by the work package ID.

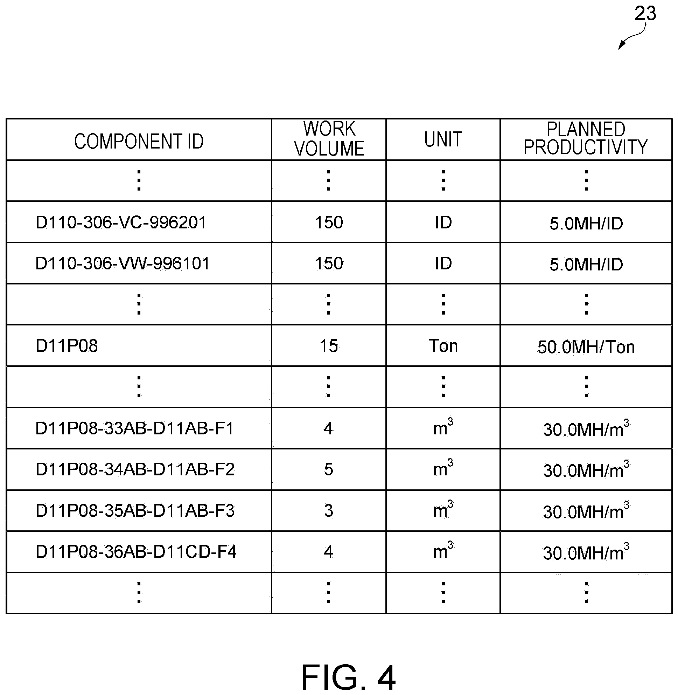

The work volume DB 23 stores a plurality of pieces of work volume information. The work volume information is set for each component. As shown in FIG. 4, each piece of work volume information contains a component ID, a work volume, and planned productivity information. The work volume is a work volume of a component identified by the component ID. When the component is a piping, the work volume is, for example, a welding amount. As a unit of the welding amount, "inch·dia (ID)" is used. The welding amount of "1 ID" means a welding amount in a case in which a piping having a diameter of one inch is welded along its entire circumference. When the component is a steel structure, the work volume is, for example, the weight of the steel structure. As a unit of the weight of the steel structure, "ton" is used. When the component is a foundation, the work volume is, for example, the volume of the foundation. As a unit of the volume of the foundation, "cubic meter (m³)" is used. As described above, a unit corresponding to the type of the component is used.

The planned productivity information is information indicating the number of hours of work required for a unit work volume. For example, as a unit of the planned productivity information on a steel structure, "MH/Ton" is used. The unit "MH" means man-hour, and is a period required when one worker performs a work. As a unit of the planned productivity information on the foundation, "MH/m³" is used. In this embodiment, the planned productivity information is set for each component, but may be set for each work type. The work volume information may not contain the planned productivity information. In this case, the user sets the planned productivity information as required.

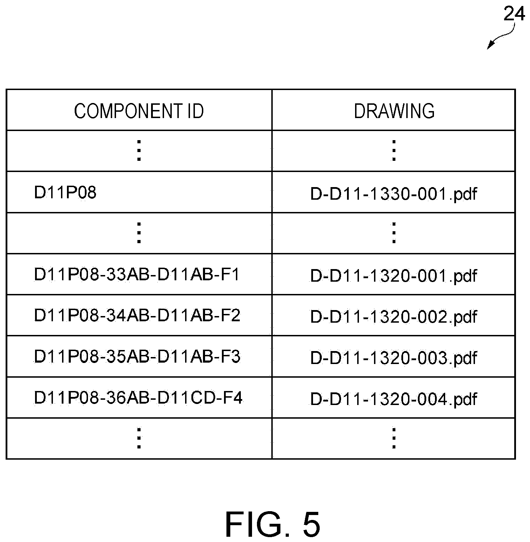

The drawing DB 24 stores a plurality of pieces of drawing information. The drawing information is set for each component. As shown in FIG. 5, each piece of drawing information contains a component ID and drawing data. The drawing data is data indicating a drawing of a component identified by the component ID. The drawing data contains layout information, for example, dimensions, information on materials, information on supports, and information on spools. The drawing data is not limited to a PDF file, and may be metadata or the like.

As illustrated in FIG. 1, the project management apparatus 10 functionally includes a reception unit 11, a display control unit 12, a registration unit 13, a setting unit 14, a generation unit 15, an adjustment unit 16, and a calculation unit 17.

The reception unit 11 is a function unit configured to receive an operation of the user. The reception unit 11 is configured to output operation information indicating details of the operation of the user to the display control unit 12, the registration unit 13, the setting unit 14, the generation unit 15, the adjustment unit 16, and the calculation unit 17.

The display control unit 12 is a function unit configured to display the simulation model of the construction object on a display apparatus (display) of the output apparatus 106. The simulation model is, for example, a 3D model of the construction object. The display control unit 12 outputs display information for displaying predetermined information to the display apparatus, and the display apparatus displays the predetermined information based on the display information. The display control unit 12 reads the model information from the model DB 21 based on an operation of the user, and displays the simulation model on the display apparatus based on the model information. When the order of a plurality of work packages is set by the setting unit 14, the display control unit 12 may display the simulation model on the display apparatus in such a form that the order is identifiable. For example, the display control unit 12 changes a display form of one or more components associated with each of the plurality of work packages from one work package to another in the simulation model, to thereby display the display forms on the display apparatus so as to visually express the order. The display control unit 12 may read the work package information from the work package DB 22 based on an operation of the user, and may display a schedule of the project generated by the generation unit 15 based on the planned schedule information of the work package information.

The registration unit 13 is a function unit configured to register one or more components in each of the plurality of work packages. The registration unit 13 registers the components in each of the work packages based on an operation of the user on the simulation model displayed on the display apparatus. A detailed description is later given of a method of registering the component. The registration unit 13 sets or adds the component ID of the registered component to the work package information on a work package to which the component is registered out of the plurality of pieces of work package information stored in the work package DB 22.

The setting unit 14 is a function unit configured to set the order of a plurality of work packages. The setting unit 14 sets the order based on an operation of the user on the simulation model displayed on the display apparatus. A detailed description is later given of a method of setting the order. The setting unit 14 sets order information to the work package information on the work packages whose order is set out of the plurality of pieces of work package information stored in the work package DB 22. When order information has already been set to the work package information, the setting unit 14 updates the order information.

The generation unit 15 is a function unit configured to generate a schedule of a project. The generation unit 15 generates the schedule based on the order set by the setting unit 14. A detailed description is later given of a method of generating the schedule. The generation unit 15 sets the planned schedule information to the work package information on each of the work packages stored in the work package DB 22 based on the schedule.

The adjustment unit 16 is a function unit configured to adjust a schedule of a project. The adjustment unit 16 adjusts the schedule based on an operation of the user. The adjustment unit 16 changes the planned schedule information of the work package information on the work package whose schedule is adjusted (changed) out of the plurality of pieces of work package information stored in the work package DB 22, to planned schedule information after the adjustment.

The calculation unit 17 is a function unit configured to calculate a work volume. The calculation unit 17 reads the work package information from the work package DB 22, and calculates the planned work volume and the actual work volume based on the work package information. The planned work volume is a work volume calculated based on the planned finish date. The actual work volume is a work volume calculated based on the work finish date. A description is later given of a method of calculating the work volume.

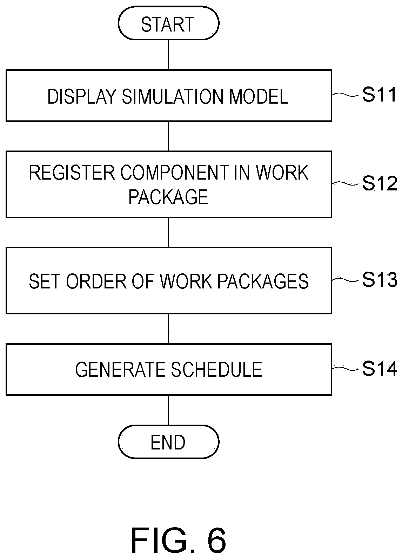

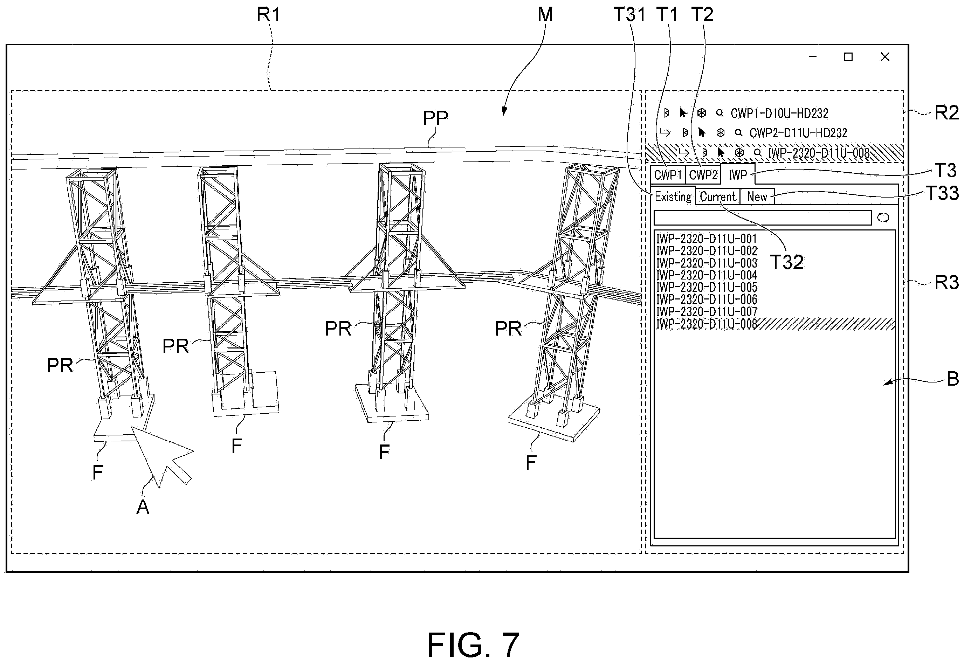

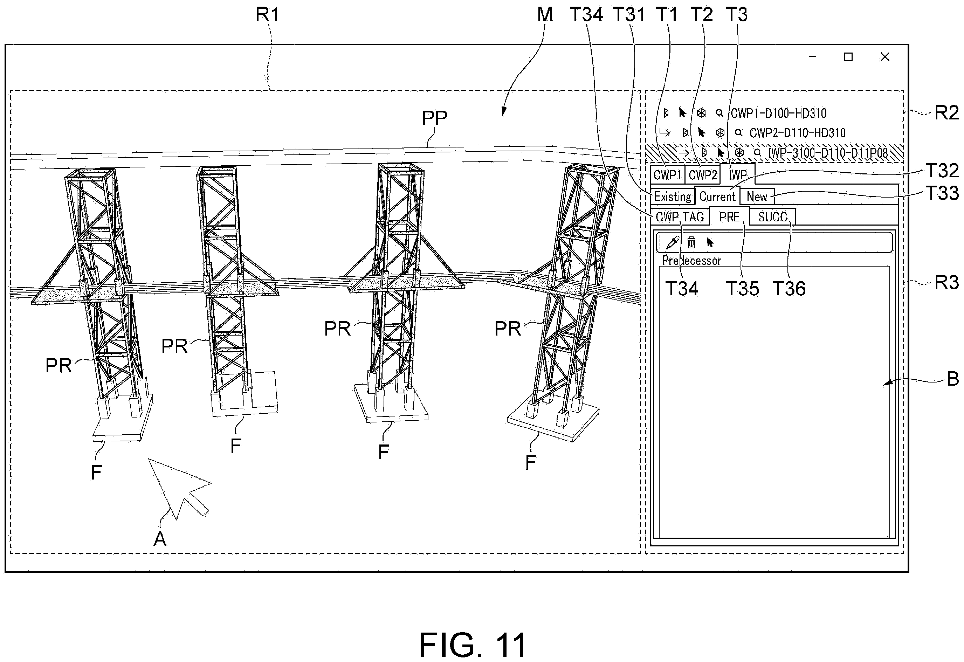

A description is now given of a project management method to be executed by the project management apparatus 10. FIG. 6 is a flowchart for illustrating a series of procedures of the project management method to be executed by the project management apparatus illustrated in FIG. 1. FIG. 7 to FIG. 10 are diagrams for illustrating the processing of registering components in work packages. FIG. 11 to FIG. 14 are diagrams for illustrating processing of setting the order of the work packages.

First, an application for executing an operation relating to a work package is activated in the project management apparatus 10. In this application, the user displays an area map, to thereby recognize a position of an area identified by an area ID. Then, the user displays a simulation model of a construction object on the display apparatus. At this time, a part of the construction object is displayed in an enlarged form. Thus, the user uses a mouse or the like to move to the area indicated by the area ID on the simulation model. In an example illustrated in FIG. 7, the user moves to an area indicated by an area ID of "D10U".

As a result, as illustrated in FIG. 7, the display control unit 12 displays a simulation model M on the display apparatus (Step S11). This simulation model M includes four foundations F, four steel structures PR, and two pipings PP. Component IDs different from one another are assigned to the respective four foundations F in advance. A common component ID is assigned in advance to the four steel structures. Component IDs different from each other are assigned to the two pipings PP.

In this example, a CWP is subdivided into CWP1s and CWP2s. CWP2s are intended for areas obtained by dividing subject areas of CWP1s. An IWP is a work unit obtained by further subdividing the CWP2. A work package ID starting from "CWP1-" indicates the CWP1. A work package ID starting from "CWP2-" indicates the CWP2. A work package ID starting from "IWP-" indicates the IWP. CWP1s and CWP2s are groups each constructed by areas and work types. Components are registered in advance in CWP1s and CWP2s through use of area IDs and work type codes indicating work types.

For example, a work package indicated by a work package ID of "CWP1-D10U-HD232" indicates a construction work for a foundation indicated by a work type code of "HD232" in an area indicated by an area ID of "D10U". A work package indicated by a work package ID of "CWP2-D11U-HD232" indicates a construction work for a foundation indicated by the work type code of "HD232" in an area indicated by an area ID of "D11U". The area indicated by the area ID of "D10U" is formed by the area indicated by the area ID of "D11U", an area indicated by the area ID of "D12U", and an area indicated by the area ID of "D13U". The work package indicated by the work package ID "CWP2-D11U-HD232" is divided into eight work packages (IWPs) indicated by work package IDs of "IWP-2320-D11U-001" to "IWP-2320-D11U-008".

The screen includes a region R1, a region R2, and a region R3. The region R1 displays the simulation model M. The region R2 displays a hierarchical structure of work packages. The region R3 is used for operations relating to the work packages. In the region R3, tabs T1 to T3 and a box B are displayed. The tab T1, the tab T2, and the tab T3 are arranged in the stated order in a widthwise direction of the screen. The box B is arranged below the tabs T1 to T3. The tab T1 is a tab for displaying a list of the CWP1s. The tab T2 is a tab for displaying a list of the CWP2s. The tab T3 is a tab for executing operations relating to the IWPs.

When the user presses the tab T1, the list of the CWP1s (work package IDs) is displayed in the box B. When the user selects one CWP1 from the list, and presses the tab T2, the list of the CWP2s (work package IDs) contained in the selected CWP1 is displayed in the box B. Further, when the user selects one CWP2 from the list, and presses the tab T3, tabs T31 to T33 are displayed between the tabs T1 to T3 and the box B. The tab T31 is a tab for displaying a list of the IWPs. The tab T32 is a tab for displaying detailed information on the IWP. The tab T33 is a tab for newly creating an IWP.

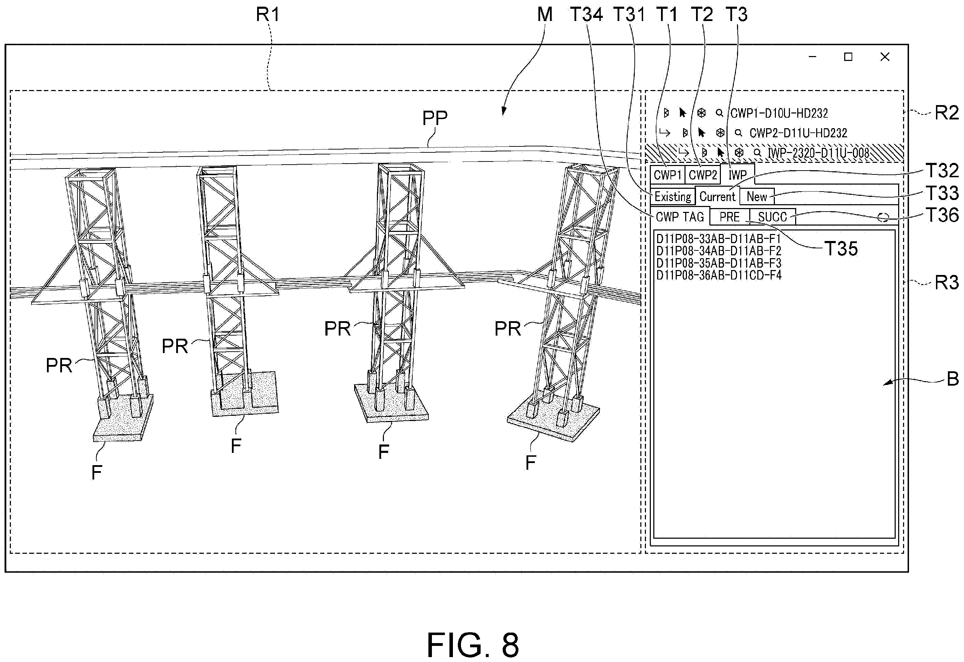

When the user presses the tab T31, a list of IWPs (work package IDs) contained in the selected CWP2 is displayed in the box B as illustrated in FIG. 7. When the user presses the tab T32, tabs T34 to T36 are further displayed between the tabs T31 to T33 and the box B as illustrated in FIG. 8. The tab T34 is a tab for displaying a list of components (component IDs) registered in the IWP. The tab T35 is a tab for registering and displaying predecessor IWPs. The predecessor IWP is an IWP to be executed before the selected IWP (current IWP), and the current IWP cannot be started before the predecessor IWP is finished. The tab T36 is a tab for registering and displaying successor IWPs. The successor IWP is an IWP to be executed after the current IWP, and the successor IWP cannot be started after the current IWP is finished.

The user uses this screen to create an IWP, and executes an operation of registering a component in a work package. First, the user grasps components existing in the area identified by the area ID from the simulation model M, and recognizes the work types thereof. In the example illustrated in FIG. 7, the four foundations F, the four steel structures PR, and the two pipings PP exist in the area indicated by the area ID of "D10U". For example, in order to create an IWP of the foundation, the user selects the CWP1 indicated by the work package ID of "CWP1-D10U-HD232", further selects the CWP2 indicated by the work package ID of "CWP2-D11U-HD232", and presses the tab T33, to thereby newly create an IWP. On this stage, a component ID, planned schedule information, actual schedule information, order information, and work volume information are not registered. The user newly creates an IWP for each of the components in the same manner.

After that, the user selects, as a current IWP, one IWP from the list of the IWPs displayed by selecting the CWP1 and CWP2 in the stated order as described above and pressing the tab T31, and uses, for example, a pointer A to select a component to be registered in the current IWP in the simulation model M. As a result, the registration unit 13 registers the selected component in the current IWP (Step S12).

In this embodiment, in the project management apparatus 10, the registration unit 13 associates the work package ID of the IWP and the component ID of the component with each other, to thereby register the component as the IWP. Then, the registration unit 13 sets or adds the component ID of the registered component to the work package information on the IWP in which the component is registered, out of the plurality of pieces of work package information stored in the work package DB 22.

In the example illustrated in FIG. 8, the four foundations F indicated by the component IDs of "D11P08-33AB-D11AB-F1", "D11P08-34AB-D11AB-F2", "D11P08-35AB-D11AB-F3", and "D11P08-36AB-D11CD-F4" are registered in the IWP indicated by the work package ID of "IWP-2320-D11U-008".

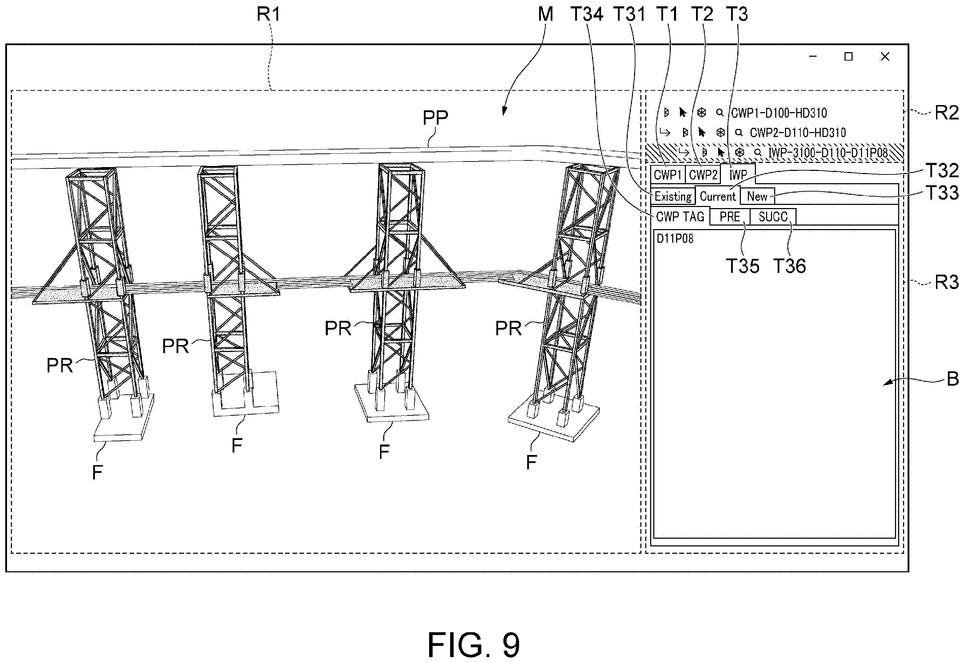

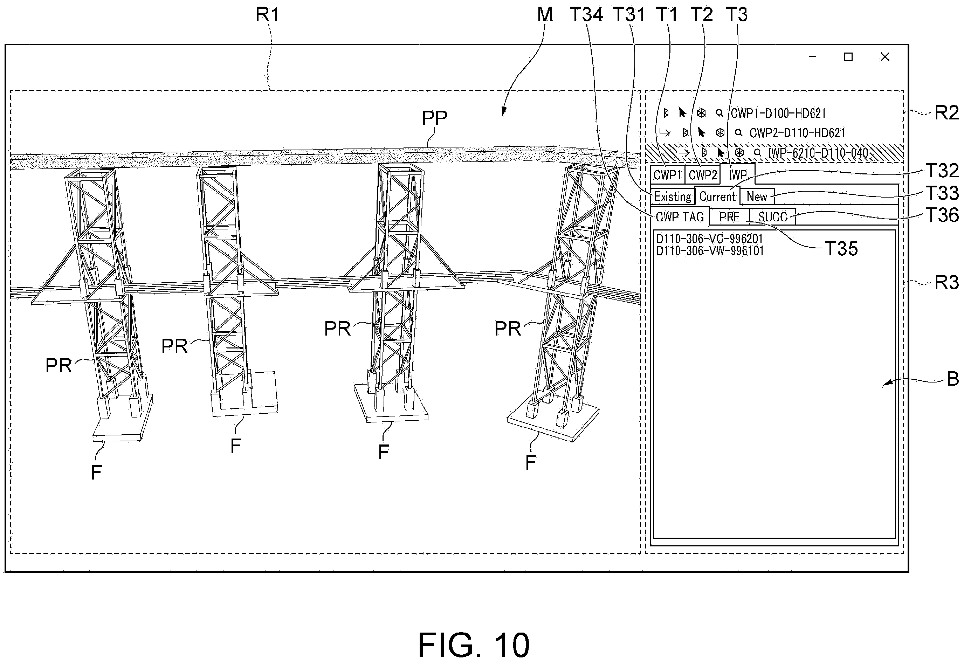

Similarly, as illustrated in FIG. 9, the four steel structures PR indicated by the component ID of "D11P08" are registered in the IWP indicated by the work package ID of "IWP-3100-D110-D11P08". As illustrated in FIG. 10, the two pipings PP indicated by the component IDs of "D110-306-VC-996201" and "D110-306-VW-996101" are registered in the IWP indicated by the work package ID of "IWP-6210-D110-040".

An operating rate of construction machines and efficiency of workers can be increased by executing works of the same type in parallel in a narrow area. Therefore, a plurality of works (components) of the same type in a narrow area are registered in the one IWP as described above. Works (components) to be performed by one work group may be registered in one IWP.

Subsequently, as described above, the user selects the CWP1, the CWP2, and the IPW in the stated order, and then presses the tab T32, and further presses the tab T35. As a result, predecessor IWPs of the current IWP are displayed in the box B. In an example illustrated in FIG. 11, none is displayed in the box B. That is, predecessor IWPs are not registered in the IWP indicated by the work package ID of "IWP-3100-D110-D11P08".

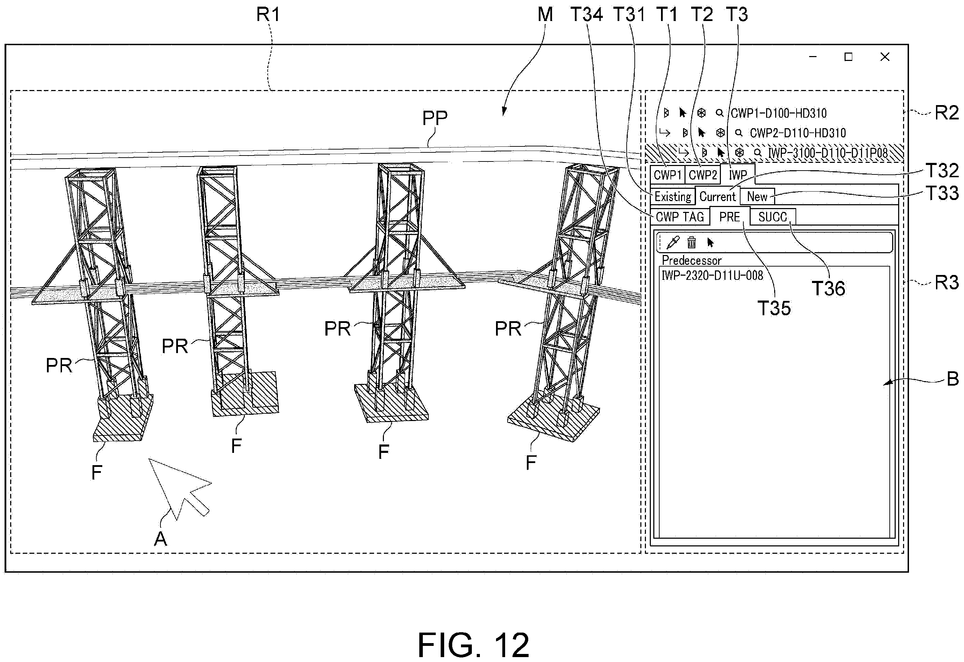

The components registered in the current IWP in the simulation model M are displayed in an identifiable form. In this example, those components are colored in, for example, green. Thus, the user visually discriminates from the simulation model M the component to be completed before the components of the current IWP, and uses the pointer A so as to select this component. Then, the IWP containing the selected component is displayed as a predecessor IWP in the box B, and is registered (Step S13). In the example of FIG. 12, the IWP indicated by the work package ID of "IWP-2320-D11U-008" is registered as the predecessor IWP.

In this embodiment, in the project management apparatus 10, the setting unit 14 associates the work package ID of the predecessor IWP with the work package ID of the current IWP, to thereby register the predecessor IWP in the current IWP. Then, the setting unit 14 sets order information to the work package information on the current IWP out of the plurality of pieces of work package information stored in the work package DB 22. In this case, the work package ID of the predecessor IWP is set as the order information.

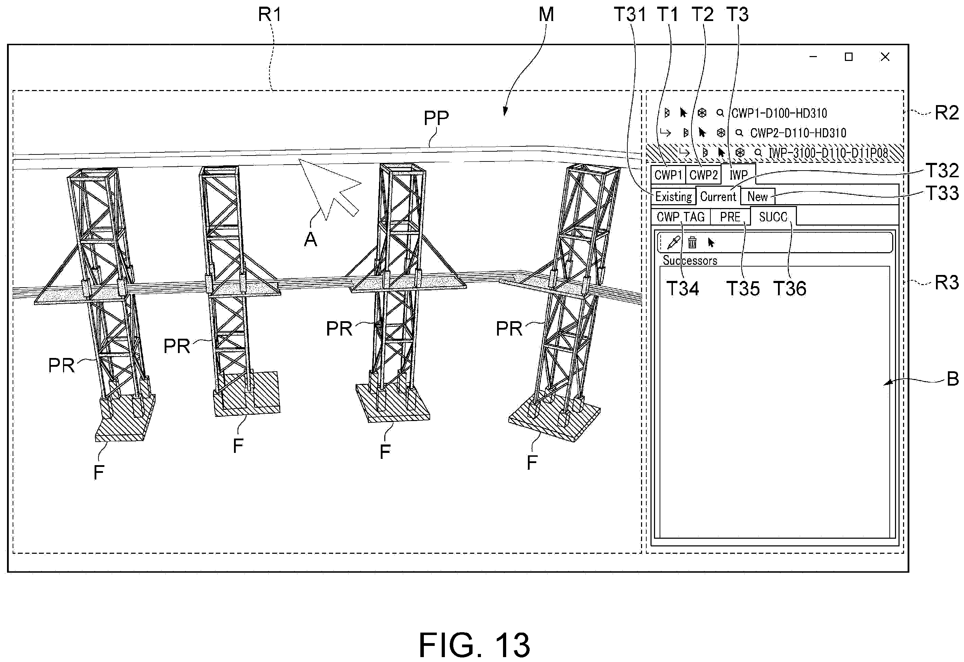

The user may select the CWP1, the CWP2, and the IPW in the stated order, and then press the tab T32, and further press the tab T36. In this case, successor IWPs of the current IWP are displayed in the box B. In an example illustrated in FIG. 13, none is displayed in the box B. That is, successor IWPs are not registered in the IWP indicated by the work package ID of "IWP-3100-D110-D11P08".

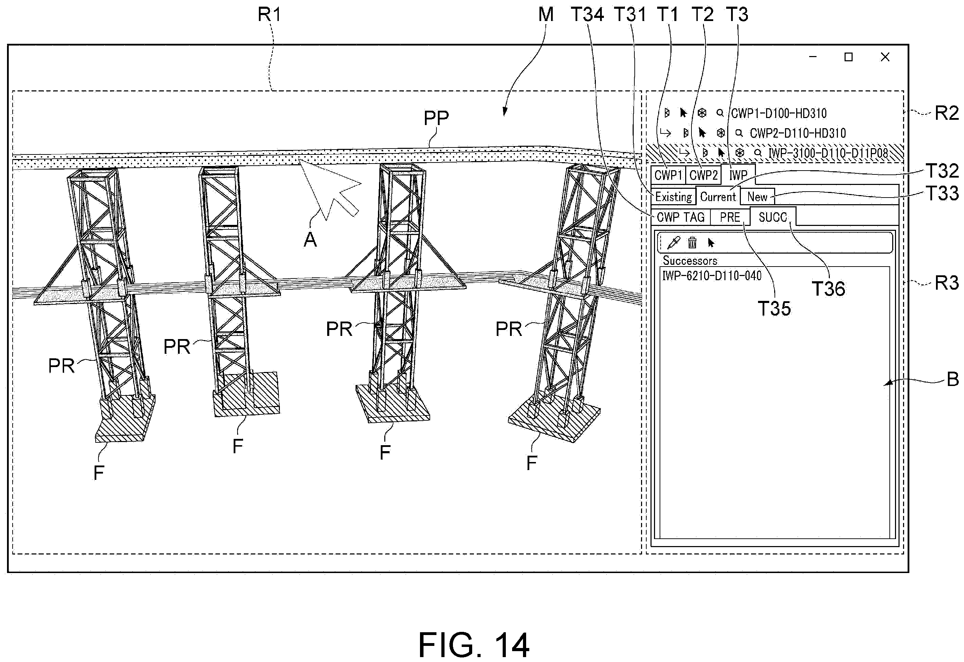

As described above, the components registered in the current IWP in the simulation model M are displayed in the identifiable form. Thus, the user visually discriminates from the simulation model M a component for which a work can be started only after the components of the current IWP are completed, and uses the pointer A so as to select this component. Then, the IWP containing the selected component is displayed as a successor IWP in the box B, and is registered (Step S13). In the example of FIG. 14, the IWP indicated by the work package ID of "IWP-6210-D110-040" is registered as the successor IWP.

In this embodiment, the setting unit 14 associates, as a predecessor IWP, the work package ID of the current IWP with the work package ID of the successor IWP, to thereby register the predecessor IWP in the successor IWP in the project management apparatus 10. Then, the setting unit 14 sets order information to the work package information on the successor IWP out of the plurality of pieces of work package information stored in the work package DB 22. In this case, the work package ID of the current IWP (predecessor IWP) is set as the order information.

The user registers the predecessor IWPs and the successor IWPs in each of the IWPs as required, to thereby set the order of the plurality of IWPs. The display control unit 12 displays the simulation model M on the display apparatus in such a manner that the order is identifiable. In this embodiment, the display apparatus changes the display form (for example, color) of components associated with each of the plurality of IWPs from IWP to another so as to visually express the order in the simulation model M. For example, green may be assigned to the components of the current IWP, pink may be assigned to the components of the predecessor IWPs, and light blue may be assigned to the components of the successor IWPs.

Subsequently, the generation unit 15 generates the schedule of the project (Step S14). In Step S14, first, schedules (planned start dates and planned finish dates) of the CWP1s and CWP2s are determined based on a schedule of the entire project. The schedules of CWP1s and CWP2s are set by, for example, the user. The schedules of the CWP1s and the CWP2s may be set in advance. Then, the generation unit 15 determines a schedule of each of the plurality of IWPs contained in the CWP2 between the planned start date and the planned finish date of the CWP2.

To describe specifically, the generation unit 15 reads the work package information from the work package DB 22, and reads the work volume information from the work volume DB 23. Then, the generation unit 15 generates the schedule (planned start date and the planned finish date) of each of the IWPs based on the work package information and the work volume information. For example, the generation unit 15 determines a performing order of the plurality of IWPs based on the order information. Then, the generation unit 15 calculates a planned period of each of the IWPs from the work volume and the planned productivity information on the components contained in each of the IWPs based on the work volume information.

Specifically, the generation unit 15 multiplies the work volume by the number of hours of work required for the unit work volume indicated by the planned productivity information, to thereby calculate the work period (MH). Then, the generation unit 15 calculates combinations between the number of workers and the planned period from the work period. For example, in a case in which the work period is 100 MH, when one worker works for 10 hours per day, the planned period is 10 days. When 10 workers work for 10 hours per day, the planned period is 1 day.

The generation unit 15 generates the schedule based on the performing order of the IWPs and the planned period of each of the IWPs. For example, the generation unit 15 selects an optimal combination from the combinations between the number of workers and the planned period of each of the IWPs so as to fit to the schedules of the CWP1s and CWP2s. The generation unit 15 generates the schedules of the plurality of IWPs contained in each of the CWP2s, to thereby generate the schedule of the entire project. Then, the generation unit 15 sets, in the work package information on this IWP, the planned start date, the planned finish date, and the planned period of each of the IWPs.

As a result, the series of procedures of the project management method is finished.

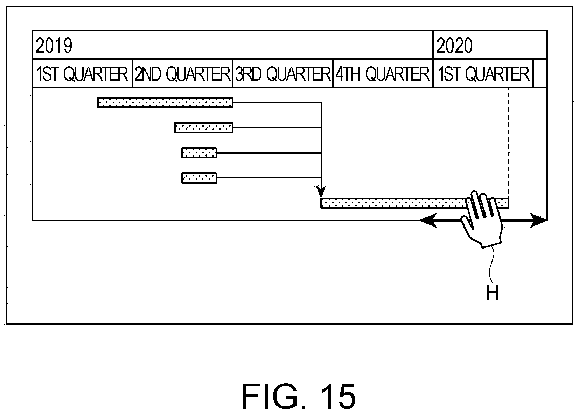

The user may finely adjust the schedule generated by the generation unit 15. FIG. 15 is a diagram for illustrating processing of adjusting the schedule. The schedule adjustment processing is started by the user selecting a desired IWP.

First, the display control unit 12 reads the work package information on the IWP selected by the user, and the predecessor IWPs and successor IWPs thereof from the work package DB 22, and displays on the display apparatus the schedules of the respective IWPs based on the work package information. In the example illustrated in FIG. 15, the schedules of the respective IWPs are illustrated as a Gantt chart. In this example, a period from the planned start date to the planned finish date of each of the IWPs is displayed as a bar, and the order (predecessor/successor relationship) between the IWPs is indicated as an arrowed line.

The user uses, for example, a pointer H to drag the bar of the IWP whose schedule the user wants to adjust, to thereby change the planned start date and the planned finish date of the IWP. Then, the adjustment unit 16 uses the planned start date, the planned finish date, and the planned period of each of the IWPs so as to update the work package information of this IWP. At this time, the adjustment unit 16 may update only the changed information.

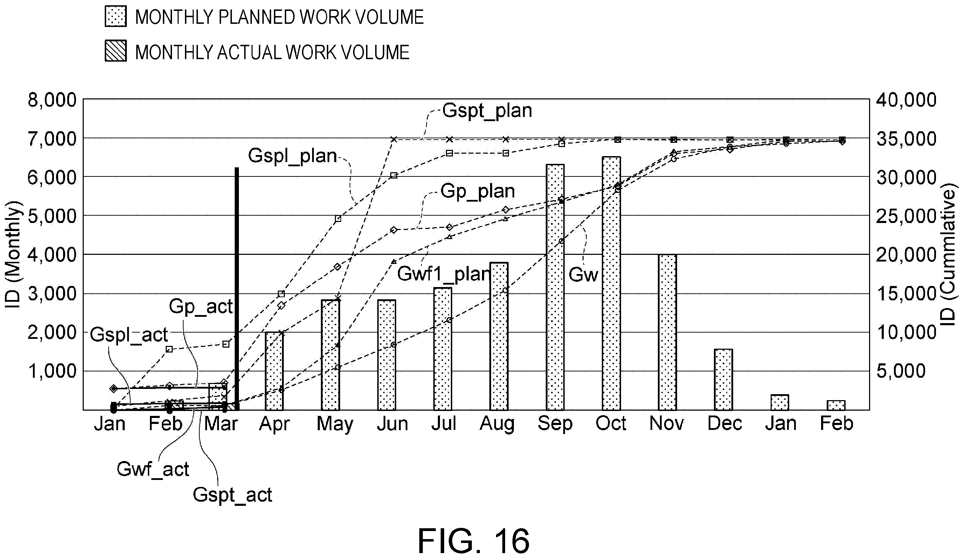

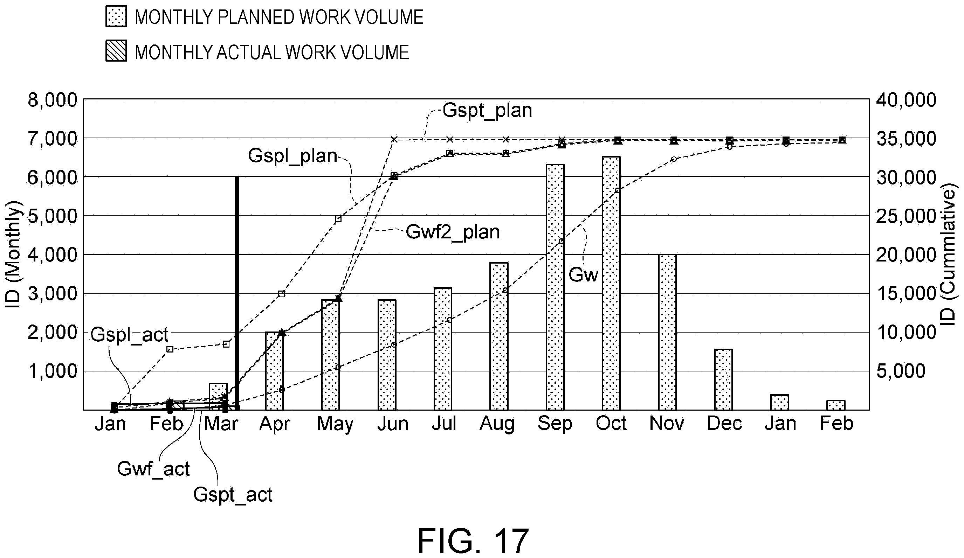

A detailed description is now given of the method of calculating the work volume. FIG. 16 is a graph for showing an example of a calculation result of work volumes. FIG. 17 is a graph for showing a comparative example of the calculation result of the work volumes. As an example, a work volume for a piping is used for the description. The work volume of the piping includes a welding amount (shop welding amount) in a plant and a welding amount (field welding amount) on site. A specific description is given below of the work volume for the piping through use of an IWP having a work volume (welding amount on site) of 819.75 inches·dia.

It is assumed that spools and supports are required to be manufactured in a factory, and predecessor IWPs are required to be completed in order to start this IWP. In this example, a planned finish date of the spool production is April 2019, and a work completion date thereof is May 2019. The work volume of the spool production is 2,000 inches·dia (shop welding amount). A planned finish date of the support production is May 2019, and a work completion date thereof is May 2019. The work volume of the support production is 10 tons. A planned finish date of the predecessor IWP is June 2019, and a work completion date thereof is July 2019. The work volume of the predecessor IWP (steel structure) is 50 tons.

The calculation unit 17 converts the work volumes of those three predecessor works into welding amounts on site. Specifically, the successor IWP having the work volume of 819.75 inches·dia can be started after the three predecessor works are completed, and the calculation unit 17 thus converts the work volume of the spool production, the work volume of the support production, and the work volume of the predecessor IWP into work volumes (819.75 inches·dia) of the respective successor IWPs.

Then, the calculation unit 17 adds, as the planned work volume, the work volume of the successor IWP to the work volume of the last planned finish date of the planned finish dates of the three predecessor works. In this example, 819.75 inches·dia are added to the work volume of June 2019. Similarly, the calculation unit 17 adds, as the actual work volume, the work volume of the successor IWP to the work volume of the last work finish date of the work finish dates of the three predecessor works. The calculation unit 17 calculates the planned work volumes and the actual work volumes for all the works as described above.

In FIG. 16, the planned work volume and the actual work volume calculated in this way are indicated as a graph Gwf1_plan and a graph Gwf1_act. An ideal planned work volume is calculated on an actual site in consideration of the predecessor IWPs. Therefore, resources, for example, workers, can efficiently be assigned based on the planned work volume.

A graph Gspl_plan is a graph obtained by adding the work volume of each of all the IWPs to the work volume of the last planned arrival date (planned finish date) of planned arrival dates (planned finish dates) of one or more spools relating to this IWP. A graph Gspl_act is a graph obtained by adding the work volume of each of all the IWPs to the work volume of the last actual arrival date (work finish date) of actual arrival dates (work finish dates) of one or more spools relating to this IWP. A graph Gspt_plan is a graph obtained by adding the work volume of each of all the IWPs to the work volume of the last planned arrival date (planned finish date) of planned arrival dates (planned finish dates) of one or more supports relating to this IWP. A graph Gspt_act is a graph obtained by adding the work volume of each of all the IWPs to the work volume of the last actual arrival date (work finish date) of actual arrival dates (work finish dates) of one or more supports relating to this IWP.

A graph Gp_plan is a graph obtained by adding the work volume of each of all the IWPs to the work volume of the last planned finish date of the planned finish dates of the one or more predecessor IWPs of the IWP. A graph Gp_act is a graph obtained by adding the work volume of each of all the IWPs to the work volume of the last work finish date of the work finish dates of the one or more predecessor IWPs of the IWP. A graph Gw is a graph obtained by accumulating a monthly planned work volume. A monthly planned work volume is a work volume required to be monthly achieved in order to complete works in accordance with the schedule of the entire project. A monthly actual work volume is a work volume obtained by monthly summing, out of the work volumes actually performed on site, work volumes for which an inspection result has no problem.

Meanwhile, as shown in FIG. 17, when the predecessor IWPs are not considered, work volumes of IWPs that have not been performed may be added as a planned work volume. Planned work volume and actual work volume calculated in this way are indicated as a graph Gwf2. Therefore, an inaccurate planned work volume is calculated, and hence the resources, for example, the workers, cannot efficiently be assigned.

Next, referring to FIG. 18, a description is given of the project management program P for causing a computer to function as the project management apparatus 10 and a recording medium MD for recording the project management program P. FIG. 18 is a diagram for illustrating a configuration of the project management program recorded in the recording medium.

As illustrated in FIG. 18, the project management program P includes a main module P10, a reception module P11, a display control module P12, a registration module P13, a setting module P14, a generation module P15, an adjustment module P16, and a calculation module P17. The main module P10 is a part configured to integrally control processing relating to the project management. Functions implemented by executing the reception module P11, the display control module P12, the registration module P13, the setting module P14, the generation module P15, the adjustment module P16, and the calculation module P17 are the same as the functions of the reception unit 11, the display control unit 12, the registration unit 13, the setting unit 14, the generation unit 15, the adjustment unit 16, and the calculation unit 17, respectively.

The project management program P is supplied in the computer-readable recording medium MD such as a compact disc-read only memory (CD-ROM), a digital versatile disc-read only memory (DVD-ROM), and a semiconductor memory. The project management program P may be supplied as a data signal through the network NW

In the project management apparatus 10, the project management method, and the recording medium having recorded thereon the project management program described above, the simulation model of the construction object is displayed on the display apparatus, and hence the user can use the simulation model to check the relationship among the plurality of work packages (IWPs). For example, the predecessor IWP can easily be discriminated. The user can set the order of the plurality of IWPs while checking the relationship among the plurality of IWPs in the simulation model in such a manner. The schedule of the project is generated based on the order set in such a manner, and hence the generation of the schedule of the project can be simplified.

The user can check the relationship among the plurality of components forming the construction object in the simulation model. For example, a plurality of components of the same type, and close to one another can be registered in one IWP. Thus, through use of the simulation model, the components can be registered in the IWP based on visual information, and hence the efficiency of the work of registering the components with the IWP can be increased.

The display control unit 12 displays the simulation model on the display apparatus in such a form that the order of the IWPs is identifiable, and hence the user can visually recognize the order of the IWPs.

The adjustment unit 16 adjusts the schedule based on the operation of the user. Therefore, the user can finely adjust the schedule as required.

The planned work volume is calculated in consideration of the predecessor IWPs, and hence the work volume actually performable on site can be obtained. Therefore, calculation accuracy of the planned work volume increases, and hence resources, for example, the workers, can efficiently be assigned based on the planned work volume.

The simulation model is a 3D model of the construction object, and hence the user can check a 3D shape of the construction object. Therefore, the user can more clearly recognize the relationship among the plurality of IWPs. As a result, the user can appropriately set the order of the plurality of IWPs, and hence the generation of the schedule of the project can further be simplified.

The project management apparatus, the project management method, and the recording medium according to this disclosure are not limited to those of the above-mentioned embodiment.

For example, the project management apparatus 10 and the server apparatus 20 may be constructed by one apparatus joined physically or logically, or may be constructed by a plurality of apparatus physically or logically separated from one another. For example, each of the project management apparatus 10 and the server apparatus 20 may be implemented by a plurality of computers distributed on a network as in the cloud computing.

The project management apparatus 10 may not include the adjustment unit 16 and the calculation unit 17. The generation of the schedule of a project can be simplified also in this configuration.

The project management apparatus 10 may use work package information in which one or more components are registered in advance so as to create a schedule. In this case, the project management apparatus 10 may not include the registration unit 13.

The project management apparatus 10 may include at least one of the model DB 21, the work package DB 22, and the work volume DB 23. Moreover, the project management apparatus 10 may include the same databases as the model DB 21, the work package DB 22, and the work volume DB 23, and may synchronize those databases with the model DB 21, the work package DB 22, and the work volume DB 23 of the server apparatus 20.

The simulation model to be displayed on the display apparatus may be a 2D model.

The project management apparatus 10 may not include the display apparatus. In this case, the display control unit 12 transmits display information to an external display apparatus, to thereby display desired information on the display apparatus.

The configurations of the model DB 21, the work package DB 22, the work volume DB 23, and the drawing DB 24 are not limited to the configurations of the embodiment. The configurations of the respective databases may be modified by a publicly-known method.

### Reference Signs List

1 ··· project management system, 10 ··· project management apparatus, 11 ··· reception unit, 12 ··· display control unit, 13 ··· registration unit, 14 ··· setting unit, 15 ··· generation unit, 16 ··· adjustment unit, 17 ··· calculation unit, 20 ··· server apparatus, 21 ··· model DB, 22 ··· work package DB, 23 ··· work volume DB, 24 ··· drawing DB, 106 ··· output apparatus (display apparatus)

## Claims

1. A project management apparatus, which is configured to manage a project of constructing a construction object, the project management apparatus comprising:
a display control unit configured to display on a display apparatus a simulation model of the construction object;
a reception unit configured to receive an operation of a user;
a setting unit configured to set an order of a plurality of work packages, which are work units for constructing the construction object, based on an operation of the user on the simulation model; and
a generation unit configured to generate a schedule of the project based on the order.

2. The project management apparatus according to claim 1, further comprising a registration unit configured to register, based on an operation of the user on the simulation model, one or more components out of a plurality of components forming the construction object in each of the plurality of work packages.

3. The project management apparatus according to claim 2, wherein the display control unit is configured to display the simulation model on the display apparatus in such a form that the order is identifiable.

4. The project management apparatus according to any one of claims 1 to 3, further comprising an adjustment unit configured to adjust the schedule,
wherein the display control unit is configured to display the schedule on the display apparatus, and
wherein the adjustment unit is configured to adjust the schedule based on an operation of the user.

5. The project management apparatus according to any one of claims 1 to 4, further comprising a calculation unit configured to calculate a work volume based on the schedule.

6. The project management apparatus according to any one of claims 1 to 5, wherein the simulation model includes a 3D model of the construction object.

7. A project management method for managing a project of constructing a construction object, the project management method comprising:
displaying on a display apparatus a simulation model of the construction object;
setting an order of a plurality of work packages, which are work units for constructing the construction object, based on an operation of a user on the simulation model; and
generating a schedule of the project based on the order.

8. A computer-readable recording medium having recoded thereon a project management program for causing a computer to manage a project of constructing a construction object, the project management program being a program for causing a computer to execute the procedures of:
displaying on a display apparatus a simulation model of the construction object;
setting an order of a plurality of work packages, which are work units for constructing the construction object, based on an operation of a user on the simulation model; and
generating a schedule of the project based on the order.
